# EUROPEAN PATENT SPECIFICATION

(11) **EP 3 200 252 B1**
(45) Date of publication and mention of the grant of the patent: **16.05.2018**
(21) Application number: 16179880.6
(22) Date of filing: 18.07.2016
(51) Int. Cl.: H01L 35/32, H01L 35/10, H01L 35/04

(54) **THERMOELECTRIC ELEMENT AND THERMOELECTRIC MODULE**
THERMOELEKTRISCHES ELEMENT UND THERMOELEKTRISCHES MODUL
ÉLÉMENT THERMOÉLECTRIQUE ET MODULE THERMOÉLECTRIQUE

(30) Priority: 26.01.2016 KR 20160009608
(43) Date of publication of application: 02.08.2017
(73) Proprietor: Hyundai Motor Company, Seoul 06797 (KR)
(72) Inventor: KWAK, Jin Woo, 38654 Gyeongsan-si, Gyeongsangbuk-do (KR); SONG, Kyong Hwa, 05819 Seoul (KR); KIM, Byung Wook, 13566 Seongnam-si, Gyeonggi-do (KR); LYO, In Woong, 16278 Suwon-si, Gyeonggi-do (KR); LEE, Han Saem, 08599 Seoul (KR)
(74) Representative: Viering, Jentschura & Partner mbB Patent- und Rechtsanwälte

(56) References cited:
- US-A1- 2008 173 537
- US-A1- 2010 154 854
- US-A1- 2010 193 004
- US-A1- 2012 018 835

## Description

### FIELD OF THE INVENTION

The present invention relates to a thermoelectric element and, more particularly, to a thermoelectric element which can be simply and accurately positioned and has a significantly increased contact area with respect to an electrode plate, and a thermoelectric module including the same.

### BACKGROUND

A thermoelectric module uses various effects appearing as heat and electricity interact with each other and has a structure using a Seebeck effect that electromotive force occurs due to a temperature difference, a structure using a Peltier effect that heat is absorbed (or generated) according to a current, and the like.

Such a thermoelectric module may include a pair of N-type thermoelectric element and a P-type thermoelectric element, an upper electrode and a lower electrode respectively connected to an upper portion and a lower portion of the N-type thermoelectric element and the P-type thermoelectric element, and an upper substrate and a lower substrate by which the upper electrode and the lower electrode are respectively supported.

A technique of precisely aligning the thermoelectric elements with respect to the electrodes and substrates is required during a process of manufacturing a thermoelectric module, and in a related art, the thermoelectric elements are aligned using a robot arm or an aligner.

The scheme using a robot arm has shortcomings in that a large amount of time is required to align thermoelectric elements as the thermoelectric elements are individually positioned.

The scheme using an aligner has shortcomings in that an operation thereof is performed onerously because a separate additional process is required to adjust a final position of a thermoelectric element.

Meanwhile, an existing thermoelectric element has a cylindrical shape or a rectangular shape and is disadvantageous in that alignment thereof may be performed onerously.

Thus, in order to precisely and quickly align thermoelectric elements, research into a thermoelectric element having a spherical shape has been conducted. However, such a spherical thermoelectric element may be easily released from a normal position even by fine vibration during alignment thereof, and thus, a defect rate during the process is increased. US 2010/154854 A1 discloses a thermoelectric element which is spherical.

In particular, since the spherical thermoelectric element has the same diameter in terms of structural characteristics, it is difficult to adjust a distance between a hot side and a cold side, causing shortcomings in that a temperature difference between the hot side and the cold side is not sufficiently secured, which leads to degradation of efficiency of the thermoelectric module.

The information disclosed in this Background of the Invention section is only for enhancement of understanding of the general background of the invention and should not be taken as an acknowledgement or any form of suggestion that this information forms the prior art already known to a person skilled in the art.

### SUMMARY

Various aspects of the present invention are directed to providing a thermoelectric element which can be simply and precisely aligned or arranged and stably secures a difference in temperature between a hot side and a cold side, thus enhancing efficiency of a thermoelectric module, and a thermoelectric module including the same.

The invention provides a thermoelectric element according to claim 1 and a thermoelectric module according to claim 3. Further embodiments are described in the dependent claims.

The methods and apparatuses of the present invention have other features and advantages which will be apparent from or are set forth in more detail in the accompanying drawings, which are incorporated herein, and the following Detailed Description, which together serve to explain certain principles of the present invention.

### BRIEF DESCRIPTION OF THE DRAWINGS

The embodiments of Figs. 2 - 4 as such do not form embodiments of the claimed invention, but help understanding the invention.
FIG. 1 is a view illustrating a thermoelectric element according to various exemplary embodiments of the present invention.
FIG. 2 is a view illustrating a thermoelectric element according to an alternative exemplary embodiment.
FIG. 3 is a view illustrating a thermoelectric element according to an alternative exemplary embodiment.
FIG. 4 is a view illustrating a thermoelectric element according to an alternative exemplary embodiment.
FIG. 5 is a view illustrating a thermoelectric module according to various exemplary embodiments of the present invention.

It should be understood that the appended drawings are not necessarily to scale, presenting a somewhat simplified representation of various features illustrative of the basic principles of the invention. The specific design features of the present invention as disclosed herein, including, for example, specific dimensions, orientations, locations, and shapes will be determined in part by the particular intended application and use environment.

In the figures, reference numbers refer to the same or equivalent parts of the present invention throughout the several figures of the drawing.

### DETAILED DESCRIPTION

Reference will now be made in detail to various embodiments of the present invention(s), examples of which are illustrated in the accompanying drawings and described below. While the invention(s) will be described in conjunction with exemplary embodiments, it will be understood that the present description is not intended to limit the invention(s) to those exemplary embodiments. On the contrary, the invention(s) is/are intended to cover not only the exemplary embodiments, but also various alternatives, modifications, equivalents and other embodiments, which may be included within the spirit and scope of the invention as defined by the appended claims.

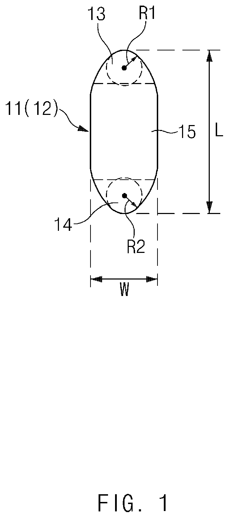

Referring to FIG. 1, thermoelectric elements 11 and 12 according to an exemplary embodiment of the present invention may include a body 15 having a predetermined length L, a first end portion 13 provided at one end of the body 15, and a second end portion 14 provided at the other end of the body 15.

The body 15 may have a cubic structure such as a cylindrical shape or an angulated shape. The body 15 may have the length L longer than a width W thereof. The length L of the body 15 may be a length by which a difference in temperature between a hot side and a cold side is secured and an increase in resistance is prevented.

The first end portion 13 and the second end portion 14 are provided at both ends of the body 15 in a length direction, and may be positioned on the mutually opposite sides of the body 15 in the length direction.

At least a partial non-flat surface is formed on at least one of the first end portion 13 and the second end portion 14, allowing each of the thermoelectric elements 11 and 12 to have a bullet shape.

In an exemplary embodiment of the present invention, since the thermoelectric elements 11 and 12 have a bullet shape, a contact area with respect to an electrode may be increased, whereby positioning and/or adhesion of the thermoelectric elements 11 and 12 may be significantly increased.

According to an exemplary embodiment of FIG. 1, the first end portion 13 may be formed as a curved portion curved to have a first radius of curvature R1 at one end of the body 15, and the second end portion 14 may be formed as a curved portion curved having a second radius of curvature R2 at the other end of the body 15.

The first radius of curvature R1 and the second radius of curvature R2 may be equal or may be different.

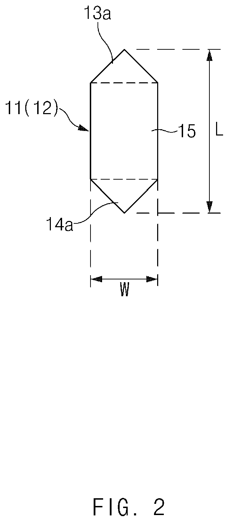

According to an exemplary embodiment of FIG. 2, a first end portion 13a and/or a second end portion 14a of the body 15 may have a conic surface or a pyramidal surface in which a width thereof is gradually decreased.

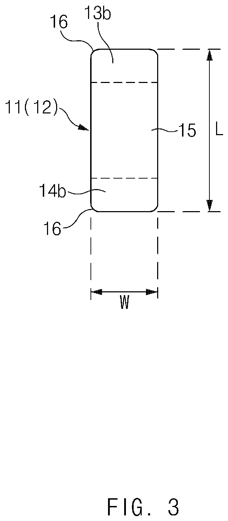

According to an exemplary embodiment of FIG. 3, a first end portion 13b or a second end portion 14b may have the same width as that of the body 15, and a rounded portion 16 having a predetermined radius may be formed at an edge of the first end portion 13b and/or the second end portion 14b.

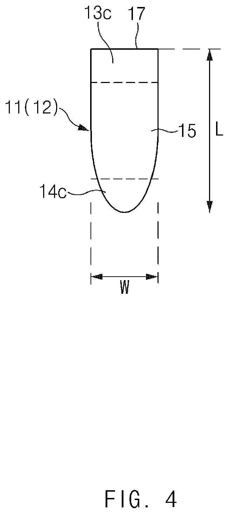

According to an exemplary embodiment of FIG. 4, a first end portion 13c may have the same width as that of the body 15, a flat surface 17 may be formed at an end of the first end portion 13c, and a second end portion 14c may have a curved portion having a predetermined radius of curvature.

In this manner, in the thermoelectric elements 11 and 12 according to an exemplary embodiment of the present invention, since the curved portion as at least a partial non-flat surface is formed on at least one end portion of the body 15, the thermoelectric elements 11 and 12 may have a bullet shape, and due to the bullet shape, a contact area with respect to electrodes 21 and 22 may be increased, significantly enhancing positioning and/or adhesion of the thermoelectric elements 11 and 12.

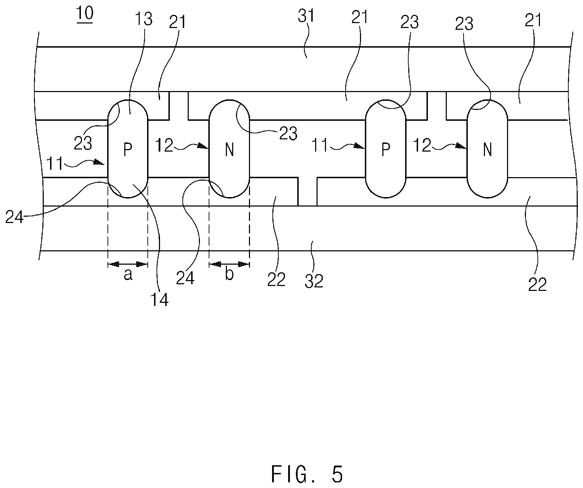

Referring to FIG. 5, a thermoelectric module 10 may include an upper substrate 31, a lower substrate 32 spaced apart from one another in a vertical direction, and a plurality of thermoelectric elements 11 and 12 and a plurality of electrodes 21 and 22 disposed between the upper substrate 31 and the lower substrate 32.

The upper substrate 31 and the lower substrate 32 may form a hot side and a cold side and each of the substrates 31 and 32 may be formed of an insulating material.

As illustrated in FIGS. 1 through 4, the plurality of thermoelectric elements 11 and 12 may have a bullet shape having at least a partial non-flat surface on at least one end portion thereof.

The plurality of thermoelectric elements 11 and 12 may include at least a pair of thermoelectric elements 11 and 12 having mutually opposite polarities, and may be formed of an N-type semiconductor and a P-type semiconductor.

The N-type semiconductor and the P-type semiconductor have different thermoelectric FIGS. of merit (ZT), and thus, the pair of thermoelectric elements 11 and 12 may be set to have different cross-sectional areas. Thus, in order to set different cross-sectional areas of the thermoelectric elements 11 and 12 having mutually opposite polarities, the pair of thermoelectric elements 11 and 12 may have different widths.

In particular, the first thermoelectric element 11 may be formed of a P-type semiconductor, and the second thermoelectric element 12 may be formed of an N-type semiconductor. In order to optimize output performance of the thermoelectric module 10, a width a of the first thermoelectric element 11 may be greater than a width b of the second thermoelectric element 12.

The upper electrode 21 may be connected to upper ends of the adjacent thermoelectric elements 11 and 12, and may have recesses 23 into which the first end portions 13 of the thermoelectric elements 11 and 12 are inserted to join may be formed in the upper electrode 21.

The lower electrode 22 may be connected to lower ends of the thermoelectric elements 11 and 12, and recesses 24 into which the second end portions 14 of the thermoelectric elements 11 and 12 are inserted to join may be formed in the lower electrode 22.

The recess 23 of the upper electrode 21 and the recess 24 of the lower electrode 22 may have a shape corresponding to the first end portion 13, 13a, 13b, or 13c, and the second end portion 14, 14a, 14b, or 14c of the thermoelectric elements 11 and 12.

FIG. 5 illustrates the thermoelectric elements 11 and 12 according to an exemplary embodiment of FIG. 1, and the recess 23 of the upper electrode 21 and the recess 24 of the lower electrode 22 may have a curved recess structure corresponding to the first and second end portions 13 and 14 formed of curved portions of the thermoelectric elements 11 and 12.

In addition, according to the exemplary embodiment of FIG. 2, since the first and second end portions 13a and 14a of the thermoelectric elements 11 and 12 are formed of a conic surface or a pyramidal surface, the recess 23 of the upper electrode 21 and the recess 24 of the lower electrode 22 may have a recess structure having a conic surface or a pyramidal surface.

According to the exemplary embodiment of FIG. 3, since the first and second end portions 13b and 14b of the thermoelectric elements 11 and 12 have a structure with the rounded portions 16, the recess 23 of the upper electrode 21 and the recess 24 of the lower electrode 22 may have a structure with a rounded portion at an edge thereof.

According to the exemplary embodiment of FIG. 4, since the first end portion 13c of the thermoelectric elements 11 and 12 has a structure with a flat surface 17, the recess 23 of the upper electrode 21 may have a structure with a flat surface, and in a case in which the second end portion 14c of the thermoelectric elements 11 and 12 has a curved structure, the recess 24 of the lower electrode 22 may have a curved recess structure.

In this manner, since the recess 23 of the upper electrode 21 and the recess 24 of the lower electrode 22 have a structure corresponding to the first and second end portions 13, 13a, 13b, 13c, 14, 14a, 14b, and 14c of the thermoelectric elements 11 and 12, the thermoelectric elements 11 and 12 may be precisely positioned in the recess 23 of the upper electrode 21 and/or the recess 24 of the lower electrode 22, adhesion thereof may be significantly enhanced, and thermal resistance and electric resistance may be reduced to enhance performance of the thermoelectric module 10.

The upper electrode 21 and the lower electrode 22 may be alternately disposed to allow a current or heat to smoothly flow.

In this manner, since the thermoelectric elements 11 and 12 have a bullet shape having at least a partial non-flat surface on at least one end portion of the body 15 thereof and the upper electrode 21 and the lower electrode 22 have the recesses 23 and 24 corresponding to the end portions of the thermoelectric elements 11 and 12 according to an exemplary embodiment of the present invention, positioning and adhesion of the thermoelectric elements 11 and 12 may be significantly enhanced, and thus, a defect rate of the thermoelectric module 10 during a manufacturing process may be minimized.

In particular, as the length L of the thermoelectric elements 11 and 12 is optimized, a distance between the hot side and the cold side of the thermoelectric module 10 may be appropriately adjusted, and thus, a temperature difference between the hot side and the cold side may be sufficiently secured.

As described above, the thermoelectric elements may be aligned or arranged simply and precisely, and also, since a temperature difference between the hot side and the cold side is stably secured, efficiency of the thermoelectric module may be enhanced.

For convenience in explanation and accurate definition in the appended claims, the terms "upper", "lower", "inner", "outer", "up", "down", "upper", "lower", "upwards", "downwards", "front", "rear", "back", "inside", "outside", "inwardly", "outwardly", "interior", "exterior", "inner", "outer", "forwards", and "backwards" are used to describe features of the exemplary embodiments with reference to the positions of such features as displayed in the figures.

The foregoing descriptions of specific exemplary embodiments of the present invention have been presented for purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof.

### SYMBOL OF EACH OF THE ELEMENTS IN THE FIGURES

11: First thermoelectric elements
12: Second thermoelectric elements
13: first end portion
14: Second end portion
15: body
21: Upper electrodes
22: lower electrodes
23, 24: Recess
31: Upper substrate
32: Lower substrate

## Claims

1. A thermoelectric element (11, 12) comprising:
a body (15) having a predetermined length (L);
a first end portion (13) provided at a first end of the body (15); and
a second end portion (14) provided at a second end of the body (15),
wherein the first end portion (13) or the second end portion (14) has at least a partial non-flat surface, **characterised in that** the first end portion (13) has a curved portion protruding out of the body (15) and having a first radius of curvature (R1), and the second end portion (14) has a curved portion protruding out of the body (15) and having a second radius of curvature (R2),
wherein the first radius of curvature (R1) is different from the second radius of curvature (R2).

2. The thermoelectric element (11, 12) according to claim 1, wherein the body (15) has a length (L) longer than a width (W) thereof.

3. A thermoelectric module (10) comprising:
at least a pair of thermoelectric elements (11, 12) disposed between an upper substrate (31) and a lower substrate (32) and having opposite polarities to each other;
an upper electrode (21) connected to upper portions of the at least a pair of thermoelectric elements (11, 12); and
a lower electrode (22) connected to lower portions of the at least a pair of thermoelectric elements (11, 12),
wherein at least an end portion (13, 14) of each of the at least a pair of thermoelectric elements (11, 12) has a partial non-flat surface, and the upper electrode (21) and the lower electrode (22) have a recess (23, 24) into which an end portion (13, 14) of each of at least the pair of thermoelectric elements (11, 12) is inserted to join thereto, **characterised in that** the first end portion (13) of each of at least a pair of thermoelectric elements (11, 12) has a curved portion having a first radius of curvature (R1), and the second end portion (14) of each of at least a pair of thermoelectric elements (11, 12) has a curved portion having a second radius of curvature (R2),
wherein the first radius of curvature (R1) is different from the second radius of curvature (R2).

4. The thermoelectric module (10) according to claim 3, wherein the at least a pair of thermoelectric elements (11, 12) includes a first thermoelectric element (11) and a second thermoelectric element (12) formed to have different widths (a, b).

5. The thermoelectric module (10) according to claim 4, wherein the width (a) of the first thermoelectric element (11) is greater than the width (b) of the second thermoelectric element (12).

6. The thermoelectric module (10) according to claim 5, wherein the first thermoelectric element (11) is formed of a P-type semiconductor and the second thermoelectric element (12) is formed of an N-type semiconductor.

7. The thermoelectric module (10) according to claim 3, wherein the recess (23) of the upper electrode (21) and the recess (24) of the lower electrode (22) have shapes corresponding to end portions (13, 14) of the at least a pair of thermoelectric elements (11, 12).

8. The thermoelectric module (10) according to claim 3, wherein the upper electrode (21) is disposed between the upper portions of the at least a pair of thermoelectric elements (11, 12) and the upper substrate (31); and
a lower electrode (22) is disposed between the lower portions of the at least a pair of thermoelectric elements (11, 12) and the lower substrate (32).

## Patentansprüche

1. Ein thermoelektrisches Element (11, 12), aufweisend:
einen Körper (15), der eine vorbestimmte Länge (L) hat,
einen ersten Endabschnitt (13), der an einem ersten Ende des Körpers (15) bereitgestellt ist, und
einen zweiten Endabschnitt (14), der an einem zweiten Ende des Körpers (15) bereitgestellt ist,
wobei der erste Endabschnitt (13) oder der zweite Endabschnitt (14) mindestens eine teilweise nicht-ebene Fläche hat,
**dadurch gekennzeichnet, dass**
der erste Endabschnitt (13) einen gekrümmten Abschnitt hat, der von dem Körper (15) aus vorsteht und einen ersten Krümmungsradius (R1) hat, und der zweite Endabschnitt (14) einen gekrümmten Abschnitt hat, der von dem Körper (15) aus vorsteht und einen zweiten Krümmungsradius (R2) hat,
wobei der erste Krümmungsradius (R1) von dem zweiten Krümmungsradius (R2) verschieden ist.

2. Das thermoelektrische Element (11, 12) gemäß Anspruch 1, wobei der Körper (15) eine Länge (L) hat, die länger als eine Breite (W) davon ist.

3. Ein thermoelektrisches Modul (10), aufweisend:
mindestens ein Paar thermoelektrischer Elemente (11, 12), die zwischen einem oberen Substrat (31) und einem unteren Substrat (32) angeordnet sind und entgegengesetzte Polaritäten zueinander haben,
eine obere Elektrode (21), die mit oberen Abschnitten des mindestens einen Paars thermoelektrischer Elemente (11, 12) verbunden ist, und
eine untere Elektrode (22), die mit unteren Abschnitten des mindestens einen Paars thermoelektrischer Elemente (11, 12) verbunden ist,
wobei mindestens ein Endabschnitt (13, 14) von jedem des mindestens einen Paars thermoelektrischer Elemente (11, 12) eine teilweise nicht-ebene Fläche hat, und die obere Elektrode (21) und die untere Elektrode (22) eine Aussparung (23, 24) haben, in welche ein Endabschnitt (13, 14) von jedem des mindestens einen Paars thermoelektrischer Elemente (11, 12) eingebracht ist, um damit verbunden zu sein,
**dadurch gekennzeichnet, dass**
der erste Endabschnitt (13) von jedem des mindestens einen Paars thermoelektrischer Elemente (11, 12) einen gekrümmten Abschnitt hat, der einen ersten Krümmungsradius (R1) hat, und der zweite Endabschnitt (14) von jedem des mindestens einen Paars thermoelektrischer Elemente (11, 12) einen gekrümmten Abschnitt hat, der einen zweiten Krümmungsradius (R2) hat,
wobei der erste Krümmungsradius (R1) von dem zweiten Krümmungsradius (R2) verschieden ist.

4. Das thermoelektrische Modul (10) gemäß Anspruch 3, wobei das mindestens eine Paar thermoelektrischer Elemente (11, 12) ein erstes thermoelektrisches Element (11) und ein zweites thermoelektrisches Element (12) aufweist, die gebildet sind, um unterschiedliche Breiten (a, b) zu haben.

5. Das thermoelektrische Modul (10) gemäß Anspruch 4, wobei die Breite (a) des ersten thermoelektrischen Elements (11) größer als die Breite (b) des zweiten thermoelektrischen Elements (12) ist.

6. Das thermoelektrische Modul (10) gemäß Anspruch 5, wobei das erste thermoelektrische Element (11) aus einem P-Typ-Halbleiter gebildet ist und das zweite thermoelektrische Element (12) aus einem N-Typ-Halbleiter gebildet ist.

7. Das thermoelektrische Modul (10) gemäß Anspruch 3, wobei die Aussparung (23) der oberen Elektrode (21) und die Aussparung (24) der unteren Elektrode (22) Formen haben, die zu Endabschnitten (13, 14) des mindestens einen Paars thermoelektrischer Elemente (11, 12) korrespondieren.

8. Das thermoelektrische Modul (10) gemäß Anspruch 3, wobei die obere Elektrode (21) zwischen den oberen Abschnitten des mindestens einen Paars thermoelektrischer Elemente (11, 12) und dem oberen Substrat (31) angeordnet ist, und
eine untere Elektrode (22) zwischen den unteren Abschnitten des mindestens einen Paars thermoelektrischer Elemente (11, 12) und dem unteren Substrat (32) angeordnet ist.

## Revendications

1. Élément thermoélectrique (11, 12) comprenant :
un corps (15) qui présente une longueur prédéterminée (L) ;
une première partie extrémité (13) disposée au niveau d'une première extrémité du corps (15) ; et
une seconde partie extrémité (14) disposée au niveau d'une seconde extrémité du corps (15) ;
dans lequel la première partie extrémité (13) ou la seconde partie extrémité (14) présente au moins une surface non plate partielle ;
**caractérisé en ce que** :
la première partie extrémité (13) présente une partie incurvée qui fait saillie hors du corps (15), et qui présente un premier rayon de courbure (R1), et la seconde partie extrémité (14) présente une partie incurvée qui fait saillie hors du corps (15), et qui présente un second rayon de courbure (R2) ;
dans lequel le premier rayon de courbure (R1) est différent du second rayon de courbure (R2).

2. Élément thermoélectrique (11, 12) selon la revendication 1, dans lequel le corps (15) présente une longueur (L) plus longue que la largeur (W) de celui-ci.

3. Module thermoélectrique (10) comprenant :
au moins une paire d'éléments thermoélectriques (11, 12) disposés entre un substrat supérieur (31) et un substrat inférieur (32), et qui présentent des polarités opposées l'une à l'autre ;
une électrode supérieure (21) connectée aux parties supérieures de la ou des paires d'éléments thermoélectriques (11, 12) ; et
une électrode inférieure (22) connectée aux parties inférieures de la ou des paires d'éléments thermoélectriques (11, 12) ;
dans lequel une partie extrémité (13, 14) au moins de chacun de la ou des paires d'éléments thermoélectriques (11, 12), présente une surface non plate partielle, et l'électrode supérieure (21) et l'électrode inférieure (22) présentent un renfoncement (23, 24) dans lequel est insérée une partie extrémité (13, 14) de chacun de la ou des paires d'éléments thermoélectriques (11, 12) de façon à s'y joindre ;
**caractérisé en ce que** :
la première partie extrémité (13) de chacun de la ou des paires d'éléments thermoélectriques (11, 12), présente une partie incurvée qui présente un premier rayon de courbure (R1), et la seconde partie extrémité (14) de chacun de la ou des paires d'éléments thermoélectriques (11, 12), présente une partie incurvée qui présente un second rayon de courbure (R2) ;
dans lequel le premier rayon de courbure (R1) est différent du second rayon de courbure (R2).

4. Module thermoélectrique (10) selon la revendication 3, dans lequel la ou les paires d'éléments thermoélectriques (11, 12) comprennent un premier élément thermoélectrique (11) et un second élément thermoélectrique (12) formés de façon à présenter des largeurs différentes (a, b).

5. Module thermoélectrique (10) selon la revendication 4, dans lequel la largeur (a) du premier élément thermoélectrique (11) est supérieure à la largeur (b) du second élément thermoélectrique (12).

6. Module thermoélectrique (10) selon la revendication 5, dans lequel le premier élément thermoélectrique (11) est constitué d'un semi-conducteur de type P, et le second élément thermoélectrique (12) est constitué d'un semi-conducteur de type N.

7. Module thermoélectrique (10) selon la revendication 3, dans lequel le renfoncement (23) de l'électrode supérieure (21) et le renfoncement (24) de l'électrode inférieure (22), présentent des formes qui correspondent aux parties extrémités (13, 14) de la ou des paires d'éléments thermoélectriques (11, 12).

8. Module thermoélectrique (10) selon la revendication 3, dans lequel l'électrode supérieure (21) est disposée entre les parties supérieures de la ou des paires d'éléments thermoélectriques (11, 12), et le substrat supérieur (31) ; et
l'électrode inférieure (22) est disposée entre les parties inférieures de la ou des paires d'éléments thermoélectriques (11, 12), et le substrat inférieur (32).
